(19) Europäisches Patentamt
European Patent Office
Office européen des brevets

(11) Publication number: **0 507 332 A2**

# (12) EUROPEAN PATENT APPLICATION

(21) Application number: **92105800.4**

(51) Int. Cl.$^5$: **B32B 15/08**

(22) Date of filing: **03.04.92**

(30) Priority: **05.04.91 JP 101911/91**
**27.12.91 JP 360142/91**

(43) Date of publication of application:
**07.10.92 Bulletin 92/41**

(84) Designated Contracting States:
**BE DE FR GB IT NL**

(71) Applicant: **KURARAY CO., LTD.**
**1621 Sakazu**
**Kurashiki-City(JP)**

(72) Inventor: **Saito, Koichi**
**5-33, Tokuyoshi-cho 2-chome**
**Okayama-city, Okayama(JP)**
Inventor: **Tsudaka, Takeichi**
**1229-1, Ouchi**
**Kurashiki-city, Okayama(JP)**

(74) Representative: **Vossius & Partner**
**Siebertstrasse 4 P.O. Box 86 07 67**
**W-8000 München 86(DE)**

## (54) Laminate.

(57) A laminate obtained by placing in layers at least one film comprising a liquid crystal polymer and at least one metal foil and pressing the resulting layers at a temperature in a range of from 80 ° C below the melting point of said liquid crystal polymer to 5 ° C below the same melting point. The film layer of the laminate has high mechanical strength. The laminate has good shape with the film layer and the metal layer being firmly bonded to each other and high thermal resistance.

EP 0 507 332 A2

The present invention relates to a laminate comprising a film comprising a liquid crystal polymer capable of forming an optically anisotropic melt phase and a metal foil.

In the field of electronic and electrical industries, there has been in recent years increasing demand for flexible printed wiring board, i.e. what is known as FPC, to meet requirement for compactization and light weight of instruments. FPC is in general constructed by laminating a metal foil such as copper foil on at least one surface of a substrate film, forming an electric circuit on the metal foil and laminating a cover film on the circuit. Polyimide films and polyethylene terephthalate films are principally used as the substrate film and the cover film.

Where an FPC is, when parts are to be mounted thereon, immersed in a molten solder bath,a polyimide film is said to be preferred as the substrate film in view of thermal resistance. Since a substrate film of polyimide has low adhesiveness to metal foil, an adhesive is generally used to bond them to each other. For this purpose there are used rubber-based, epoxy resin-based, phenol resin-based or acrylic adhesives. The use of adhesives tends to cause uneven adhesion due to non-uniformity in composition or uneven curing. Further the above adhesives do not always have sufficient thermal resistance and the bond strength decreases at high temperatures. Thus, the heat-resistant temperature of FPC depends virtually upon that of the adhesive used so that it is often the case that thermal resistance originally possessed by the substrate polyimide film does not fully exhibit.

On the other hand, a polyethylene terephthalate film can be attached to a metal film by pressing without using any adhesive. Japanese Patent Publication No. 46786/1984 describes that a polyethylene terephthalate film having a degree of crystallinity of at least 30% can adhere to a metal foil to give a laminate useful as FPC, by passing the two between a heated metal roll and a heat resistant rubber-covered roll at a temperature of at least 80°C higher than the glass transition temperature and not higher than the melting point of the polyethylene terephthalate and under a pressure of 0.01 to 20 $kg/cm^2$. Such a laminate however is, not being of sufficient thermal resistance, limited in its use for applications requiring large thermal resistance.

Resin films comprising liquid crystal polymers capable of forming an optically anisotropic melt phase have been attracting much attention, as having better thermal resistance and far different characteristics than polyethylene terephthalate films. Attempts have been made to have such liquid crystal polymer films to adhere, without the use of any adhesive, to metal foils to obtain laminates which are processable into substrates for printed wiring board and the like. For example , US-A-4,717,624 describes that a laminated plate was obtained by laying a sheet comprising a liquid crystal polymer consisting of 70 mole % of units from p-hydroxybenzoic acid and 30 mole % of units from 6-hydroxy-2-naphthoic acid on a metal sheet and pressing the two with a 50-t press at a temperature of 300°C. JP-A-252738/1990 describes that it is desirable to heat press onto a metal plate a sheet comprising a liquid crystal polymer with at least its surface being melted. The application gives an example where a sheet comprising a liquid crystal polymer was sandwiched between 2 sheets of metal plate and heat pressed at a temperature at which the liquid crystal polymer melts, to give a laminated plate.

US-A- 4,966,807 describes an example where at least 2 sheets of a film produced from a liquid crystal polymer of Xydar® SRT300 or Vectra® B900 were bonded together by placing the sheets in layers and heat pressing under a pressure of 100 to 250 psi for a period of for example 1 to 2 minutes, and the obtained laminate was further laminated with a metal foil by heat pressing under the same conditions of temperature and pressure and for a period of for example 2 minutes.

It has now been found that unfavorable results often occur by heat pressing of a liquid crystal polymer film with a metal foil at a high temperature above the melting point of the liquid crystal polymer as described in the above U.S. Patent US-A-4,717,624 or JP-A-252738/1990.

That is, the high mechanical strength originally possessed by the liquid crystal polymer film often deteriorates and the obtained laminate often has a poor shape, whereby the obtained laminate is not always suited for use in applications, such as FPC, where high mechanical strength and dimensional accuracy are required for the film layer itself.

Besides, since the process disclosed in US-A-4,966,807 comprises using a laminated film obtained by joining a plurality of liquid crystal polymer films with each other beforehand and conducting the pressing incontinuously, it is difficult to produce with high productivity a laminate having uniform properties including resistance to delamination.

Accordingly, an object of the present invention is to provide a laminate having high resistance to delamination and good shape, with its film layer exhibiting high mechanical properties, which laminate is obtainable by directly and firmly bonding a film comprising a liquid crystal polymer to a metal foil without deteriorating the high mechanical properties inherent to the film.

Another object of the present invention is to provide an industrially advantageous process for producing

the above laminate uniformly and with high productivity.

Still another object of the present invention is to provide an FPC having high mechanical properties and high resistance to delamination and heat.

The present invention provides a laminate comprising a laminated structure obtained by placing in layers at least one film comprising a liquid crystal polymer capable of forming an optically anisotropic melt phase and at least one metal foil and pressing the resulting layers by passing them through a nip between press rolls at a temperature in a range of from 80 °C below the melting point of the liquid crystal polymer to 5 °C below the same melting point.

The present invention further provides a laminate comprising a laminated structure obtained by placing in layers at least one single-layer film comprising a liquid crystal polymer capable of forming an optically anisotropic melt phase and at least one metal foil and pressing the resulting layers at a temperature in a range of from 80 °C below the melting point of the liquid crystal polymer to 5 °C below the same melting point.

The present invention still further provides a process for producing laminates which comprises placing in layers at least one film comprising a liquid crystal polymer capable of forming an optically anisotropic melt phase and at least one metal foil and pressing the resulting layers by passing them through a nip between press rolls at a temperature in a range of from 80 °C below the melting point of the liquid crystal polymer to 5 °C below the same melting point.

The present invention yet further provides an FPC obtained by chemically etching the either one of the above laminates and comprising a film comprising a liquid crystal polymer and a metal foil forming electric circuit, said film and said metal foil being laminated with each other.

DETAILED DESCRIPTION OF THE PREFERRED EMBODIMENTS

The liquid crystal polymers usable in the present invention are those capable of forming optically anisotropic melt phase, i.e. what are known as thermotropic liquid crystal polymers. Such polymers capable of forming optically anisotropic melt phase have, as is well known in the art, the feature of transmitting polarized light, when their specimens in the melted state are observed under a crossed nicol with a polarization microscope equipped with a heating device.

Known thermotropic liquid crystal polyesters or polyester amides derived from compounds exemplified in the following groups (1) through (4), or their derivatives can be used in the present invention. Suitable combination and the amounts used of the starting material compounds are necessarily selected for obtaining a polymer capable of forming thermotropic liquid crystal.

(1) Aromatic or aliphatic dihydroxy compounds

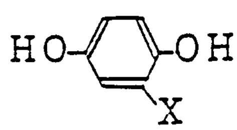

wherein X represents a hydrogen atom, a halogen atom or a lower alkyl, phenyl or like groups;

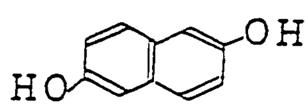

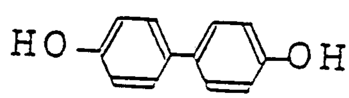

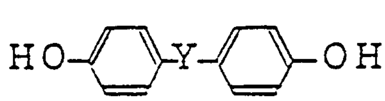

wherein Y represents -O-, $-CH_2-$, -S- or like groups;

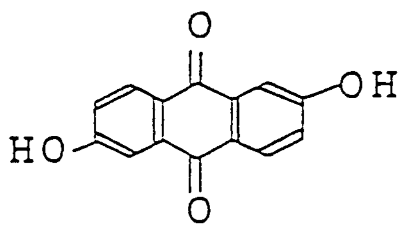

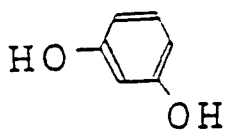

$HO(CH_2)_nOH$

wherein n represents an integer of 2 to 12.

(2) Aromatic or aliphatic dicarboxylic acids

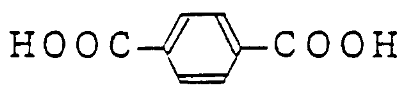

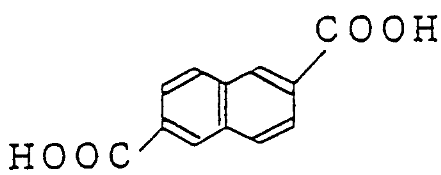

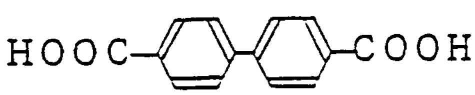

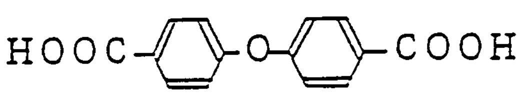

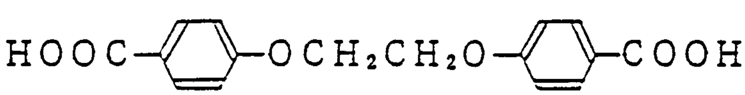

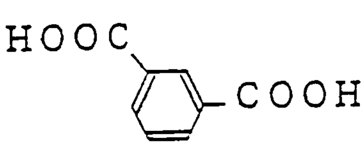

$HOOC(CH_2)_nCOOH$

wherein n represents an integer of 2 to 12.

(3) Aromatic hydroxycarboxylic acids

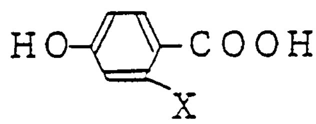

wherein X represents a hydrogen atom, a halogen atom or a lower alkyl, phenyl or like groups.

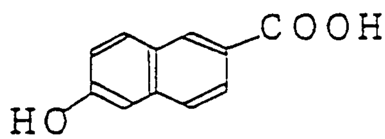

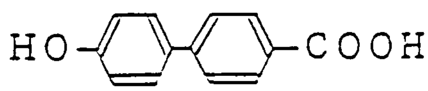

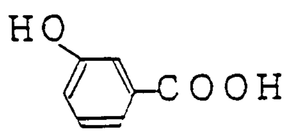

(4) Aromatic diamines, aromatic hydroxy amines or aromatic aminocarboxylic acids

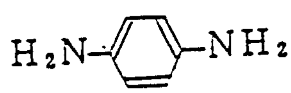

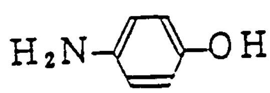

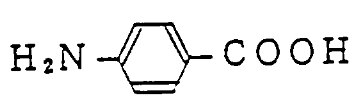

Representative examples of the liquid crystal polymer are the following copolymers (a) through (e) having various structural units.

(a) Copolymers consisting of

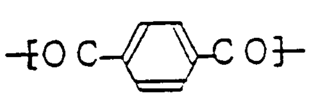 , 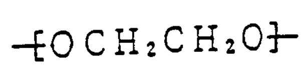 and 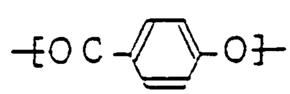

(b) Copolymers consisting of

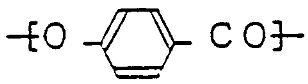 and 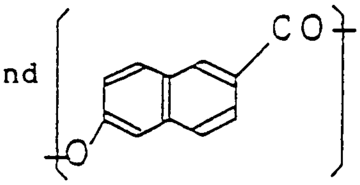

(c) Copolymers consisting of

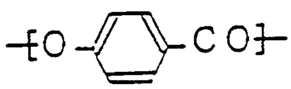 , 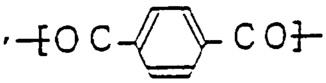 , 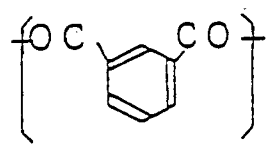

and

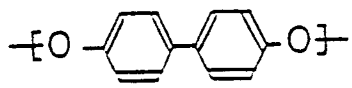

(d) Copolymers consisting of

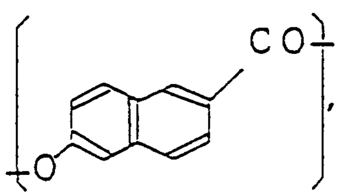 , 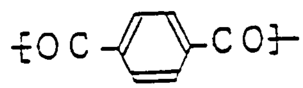

and

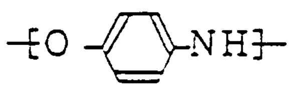

(e) Copolymers consisting of

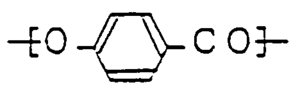 , 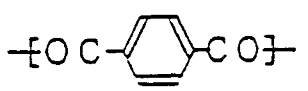 ,

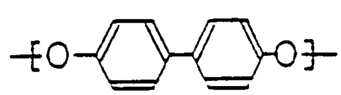

and

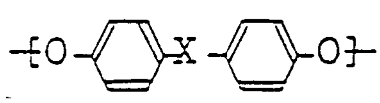

wherein X represents -O-, $-CH_2-$, -S- or like groups.

Among the above, thermotropic liquid crystal polyesters consisting essentially (preferably in amounts of

at least 95 mol% of the total structural units) of the following structural units (I) and (II)

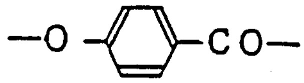

(I)

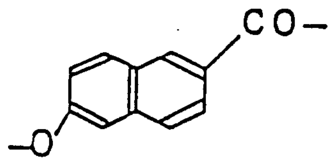

(II)

are preferred because of their high processability and high thermal resistance of films obtained therefrom. In such thermotropic liquid crystal polyesters, the molar ratio between the structural unit (I) and the structural unit (II), [(I)/(II)], is preferably in a range of 90/10 to 10/90, more preferably in a range of 85/15 to 65/35 and most preferably in a range of 80/20 to 70/30.

The liquid crystal polymers used in the present invention preferably have a transition temperature to an optically anisotropic melt phase of 200 to 400°C, in particular 250 to 350°C, in view of the thermal resistance and processability of film. They may incorporate a lubricant, an antioxidant, a filler or other usual additives within limits not to impair the properties of the resulting films.

In the present invention, films comprising the above liquid crystal polymers preferably have a thermal expansion coefficient of not more than 1.0 x $10^{-5}$ (1/°C). Where the film and a metal foil, in particular copper foil, are heat pressed, large difference between the thermal expansion coefficients of copper and the film may cause the obtained laminate to curl or warp when returned to room temperature. Similar trouble may occur when the obtained laminate, which is to be used as FPC, immersed in a molten solder bath for the purpose of mounting parts thereon.

The liquid crystal polymers used in the present invention are formed into films by any known process such as T-die process or tubular film process. If once melted and then cooled, the liquid crystal polymers used in the present invention generally become difficult to biaxially stretch in the usual manner. It is therefore desirable to stretch a film, leaving the exit of a molding die and before cooling, both in the machine direction (hereinafter referred to as "MD") and in a direction perpendicular to the machine direction (hereinafter referred to as "TD") at the same time. Then, the mechanical properties both in MD and TD of the obtained film will be increased. Machine shear orientation may also occur due to conventional machine direction flow, or due to moving die surfaces, e.g. in rotating or counter-rotating annular dies. The film obtained may further be heat treated as required.

The films comprising liquid crystal polymers and used in the present invention preferably have a thickness of not more than 500μm, more preferably 10 to 500μm, most preferably 10 to 250μm. The thickness unevenness is preferably within ± 10%, more preferably within ± 5%. The liquid crystal polymer films used in the invention may be provided with one or more layer of resin or metal laminated on the other surface thereof than that to be laminated with a metal foil by pressing according to the invention. It is however desirable that the films comprising liquid crystal polymers and used in the present invention be single-layer films because of no delamination occurring at heat pressing. High pressure conditions can then be employed upon heat pressing a single-layer film with a metal foil, thereby readily yielding a laminate having high resistance to delamination.

The metallic material forming the foil used in the present invention is selected from those usable for electrical connection and its preferred examples are gold, silver, copper, nickel and aluminum, among which copper is more preferable. Copper foils produced either by rolling or by electrolysis may be used, the latter being preferred in view of surface roughness though. The metal foil used may have been chemically treated by acid washing, which is generally applied to copper foils, insofar as the function and effect of the present invention are not impaired. The metal foil used preferably has a thickness of 10 to 1000μm, more preferably 15 to 150μm.

In the present invention, adhesion of at least one film comprising liquid crystal polymer and at least one metal foil is effected by heat pressing at a temperature in a range of from 80°C lower than the melting point of the liquid crystal polymer to 5°C lower than the same melting point. With the use of press rolls, continuous adhesion operation under uniform pressing conditions becomes possible, whereby uniform laminates can be produced with high productivity.

A simple and preferred process for heat pressing the film and the metal foil at a temperature in the above range comprises placing in layers at least one film and at least one metal foil and pressing the

resulting layers by passing them between press rolls including at least one heated roll having a surface temperature in a range of from 80 ° C lower than the melting point of the liquid crystal polymer to 5 ° C lower than the same melting point. In this process, the film and metal foil laid one upon another are, when passing through the nip between press rolls including at least one roll heated to a temperature within the above range, simultaneously pressed and heated to substantially the same temperature as that of the heated roll. The film does not substantially melt under the heat pressing condition employed in the present invention. While the press rolls comprise at least 2 rolls, if the pressing temperature is, on all of the press rolls, lower than the melting point of the liquid crystal polymer by not less than 80 ° C, the film will not adhere to the metal foil at all or, if adhesion ever occurs, the obtained laminate will readily delaminate. On the other hand, if the pressing temperature exceeds a temperature 5 ° C lower than the same melting point, the mechanical properties of the film will decrease to a large extent during the heat pressing, whereby the film layer in the obtained laminate has insufficient mechanical strength. Besides, with such too high a pressing temperature, there even occur cases that the film flows and the metal foil deforms significantly to give laminates with poor shape. The pressing temperature is preferably in a range of from 60 ° C lower than the melting point of the liquid crystal polymer to 10 ° C lower than the same temperature, because laminates being particularly excellent in all of the mechanical strength of the film layer, resistance to delamination and shape are then obtained.

The term "the melting point of a liquid crystal polymer" herein is a temperature where the endothermic peak of melting is observed by differential scanning calorimetry (DSC) when a specimen of the film of the liquid crystal polymer to be subject to the pressing is heated at a temperature elevation rate of 10 ° C/min.

Known press rolls are appropriately selected and used in the present invention and their examples are metal rolls, rubber rolls and metal rolls coated with rubber or a resin such as polyimide. It is desirable to use, as at least one of the press rolls used, a roll having a rubber surface, such as a metal roll coated with rubber or a rubber-made roll, in particular one with its surface rubber having a spring hardness (JIS A) as determined according to TYPE-A SPRING HARDNESS TEST given in JIS K6301 of at least 80 degrees. Pressing of a material by contact with a hard rubber as having the hardness of at least 80 degrees can apply a high pressure of at least 20 kg/cm$^2$ as converted into pressure per area. Under such a high pressure, there can readily be minimized dispersion in resistance to delamination, which often occurs in pressing together of thin materials, such as film and metal foil, and is attributable to the thickness unevenness of the thin materials. Rubbers having a hardness of at least 80 degrees may be obtained by vulcanizing and hardening synthetic rubbers such as silicone-rubber and fluoro-rubber or natural rubber by incorporation of a vulcanizing agent, vulcanization accelerator such as alkaline substance, reinforcing filler such as anisotropic filler and like ingredients. The hardness of the rubber used is preferably not higher than 95 degrees in view of uniformity of the resistance to delamination of the obtained laminate.

In the present invention, the preferred pressure applied to a film and a metal foil when they pass between press rolls depends on the combination of the press rolls. Thus, with a combination of metal rolls only, where substantially no deformation occurs on the pressing part of the rolls, a liner pressure of at least 5 kg/cm, preferably at least 10 kg/cm is desirable for the purpose of developing sufficient resistance to delamination. With combinations where the press rolls include at least one roll with a rubber surface, the pressure applied to a film and a metal foil is better expressed in terms of areal pressure than linear pressure because the degree of deformation of the pressing part of the rubber surface changes with pressure and the material of the surface rubber. Such combinations include a metal roll with or without surface-coating rubber layer and a metal roll surface-coated with rubber or a rubber roll, and the desirable areal pressure is at least 20 kg/cm$^2$. An areal pressure of at least 20 kg/cm$^2$ produces, as described above, particularly large effect of developing sufficient resistance to delamination with minimum unevenness.

There are no particular restrictions with respect to the upper limit of the pressure applied, but too high a pressure cannot develop corresponding high adhesiveness and may often cause the film to break. It is therefore desirable that the pressure do not exceed 400 kg/cm in terms of linear pressure or 100 kg/cm$^2$ in terms of areal pressure. In these cases, the film suffers a small deformation at the nip of between the press rolls, but it restores its thickness after having passed the nip, whereby there is no substantial difference between the thicknesses of the film before and after the pressing.

The linear pressure applied by press rolls herein is the quotient obtained by dividing the force (load) applied to the press roll by the effective width of the roll. The areal pressure herein is the quotient obtained by dividing the load applied to the press roll by the area of the pressing surface formed by deformation of the press roll. The press rolls used in the present invention preferably have a diameter of 200 to 1,000 mm, more preferably 300 to 600 mm.

In the present invention, the rotation speed of the press rolls permitting a film and a metal foil to pass therethrough, at a temperature in a range of from 80 ° C below the melting point of the liquid crystal polymer

constituting the film to 5°C below the same melting point, is preferably not more than 30 m/min, more preferably not more than 20 m/min as converted into the linear speed of the circumference of the roll, for the purpose of developing high resistance to delamination without unevenness. Although the rotation speed has no specific lower limit, it is desirable in commercial production to maintain the speed not lower than 0.5 m/min because too low a speed will decrease productivity.

There are no particular limitation to the arrangement of the press rolls used in the invention. For instance a pair of rolls that constitute the press rolls may be so arranged that their axes are contained in a vertical plane, or their axes may be contained in an inclined plane against vertical plane. It is often advantageous to arrange a heated metal roll and a rubber roll or rubber-coated metal roll such that their axes are contained in an inclined plane and to introduce horizontally a film and a metal foil, being laid one upon another, such that they are first contacted with the bottom heated roll and then pressed beneath the top rubber roll or rubber-coated metal roll. In this case pressing can be applied while generation of any crease is prevented, whereby the obtained laminate has good shape. Thus, in the present invention, the film and/or metal foil to be pressed may be preheated before the pressing.

The laminate of the present invention obtained by the above process is not limited to the 2-layer laminate consisting of a film comprising a liquid crystal polymer and a metal foil and includes multilayered structures containing at least one film layer and at least one metal foil, e.g. 3-layer structures such as metal foil/film/metal foil, film/metal foil/film and film/film/metal foil, and 5-layer structures such as metal foil/film/metal foil/film/metal foil.

In accordance with the present invention, it is possible to conduct adhesion of film and metal foil at not less than 2 different surfaces at the same time. For instance, a 3-layer structure of metal foil/film/metal foil can be produced by heat pressing a film and 2 metal foils, each of the metal foils being laid on both sides of the film.

The laminate of the present invention has a good shape, and maintains the high mechanical strength and thermal resistance inherent to the constituting film comprising a liquid crystal polymer, with the film layer and metal layer being firmly bonded to each other under room-temperature condition as well as under high temperature conditions. The laminate of the present invention includes those having a resistance to delamination between the film layer and the metal foil layer heat pressed by the above process as measured at a room temperature (15 to 25°C) by 180° peeling test of at least 0.5 kg/cm, and further those having the resistance to delamination of at least 0.7 kg/cm.

The laminates of the present invention, having the above features, are useful as materials for producing e.g. FPC, tapes for TAB (tape automated bonding), packaging materials and heat insulating materials. FPC and TAB can for example be produced by etching in the usual process the laminate of the present invention such that the metal foil layer forms the desired electric circuit pattern and further, as required, subjecting the resulting laminate to after-processing such as lamination with a cover film or perforation.

According to the process of the present invention, it is possible to produce through simple operation and with high productivity uniform laminates having good shape and excellent thermal resistance, as well as high mechanical strength of the constituting film layer comprising a liquid crystal polymer and high resistance to delamination between the film layer and the constituting metal foil layer.

Having generally described this invention, a further understanding can be obtained by reference to certain specific examples which are provided herein for purpose of illustration only and are not intended to be limitative of this invention unless otherwise specified.

In the Examples and Comparative Examples that follow, the laminates obtained were evaluated according to the following methods.

(1) Visual observation of laminates

The laminates were visually inspected for crease and deformation.

(2) Resistance to delamination

(2-1) Method A

From the specimen laminate before and after heat cycle test, 2-cm wide test samples were taken and tested for resistance to delamination by 180° peeling method. The heat cycle test was conducted by 10 cycles according to JPCA-RB03.

(2-2) Method B

Test samples of 1.5-cm wide were taken from the laminate and, after being allowed to stand at 20°C, 65% RH for 2 days, tested for resistance to delamination by 180° peeling method under the same condition. For checking the unevenness of the resistance, at least 5 samples taken from optional places of the laminate were tested and the difference between the maximum resistance to delamination and the minimum resistance was reported as the range of the resistance to delamination.

(3) Molten solder-heat resistance

Test samples having a size of 2.5 cm x 2.5 cm were taken from the laminate and immersed in a molten solder bath at 260°C for 10 seconds. They were then visually inspected for deformation and delamination.

(4) Tensile strength of film layer

The specimen laminate was immersed in a 400 g/l aqueous ferric chloride solution at 40°C for 20 minutes, whereby the copper layer was dissolved off. The remaining film was tested for tensile strength (MD) according to JIS K6854.

Reference Example 1

A reaction vessel equipped with a stirrer and a vacuum distillation column was charged with 70 parts by weight of p-acetoxybenzoic acid and 30 parts by weight of 6-acetoxy-2-naphthoic acid. The inside of the vessel was fully replaced by nitrogen gas, and the vessel was heated to a temperature of 250°C while nitrogen gas was being streamed thereinto. The contents were stirred at 250°C for 3 hours and then at 280°C for 1 hour and a quarter. The polymerization temperature was elevated to 320°C and the system was kept at the temperature for 25 minutes. The system was then gradually evacuated and kept under the conditions of 0.1 to 0.2 mmHg and 320°C for 25 minutes, after which the inside pressure was returned to atmospheric pressure and the obtained polymer was withdrawn.

The polymer thus obtained was capable of forming an optically anisotropic melt phase and had a melt viscosity as measured under the conditions of 300°C and a shear rate of 100 $sec^{-1}$ of 2,700 poise.

The polymer was formed into a film having a thickness of 80μ m by tubular film process using a single-screw extruder at a heating temperature of 280 to 300°C and under the conditions of a draw ratio of 2.4 and a blow ratio of 2.2. The film thus obtained had a good appearance and showed a melting temperature as measured by DSC and at a temperature elevation rate of 10°C/min of 275°C.

Examples 1 through 10 and Comparative Example 1

The film obtained in Reference Example 1 was laid, one upon another, with a foil of electrolytic copper having a thickness of 18μ m and a surface roughness of 11μ m and heat pressed by passing through the nip between press rolls consisting of a rubber roll having a hardness of 90 degrees and a chrome-plated iron roll. When entering the rolls, the film contacted the rubber roll and the copper foil contacted the iron roll. The iron roll was heated with a housed-in electric heater. The surface temperature, areal pressure, linear pressure and linear speed of the iron roll in each of the Examples are shown in Table 1. The results of evaluation on each of the obtained laminates are shown in Table 2.

The film layers of the laminates obtained in Examples 1 and 5 showed tensile strengths of 32 $kg/mm^2$ and 27 $kg/mm^2$, respectively.

Table 1

| | Surface temperature (°C) | Areal pressure ($kg/cm^2$) | Linear pressure (kg/cm) | Linear speed (m/min) |
|---|---|---|---|---|
| Example 1 | 250 | 25 | 38 | 1 |
| 2 | 200 | 25 | 38 | 1 |
| 3 | 225 | 25 | 38 | 1 |
| 4 | 260 | 25 | 38 | 1 |
| 5 | 270 | 25 | 38 | 1 |
| 6 | 250 | 9.5 | 4 | 1 |
| 7 | 250 | 21 | 10 | 1 |
| 8 | 250 | 35 | 90 | 1 |
| 9 | 250 | 25 | 38 | 20 |
| 10 | 250 | 25 | 38 | 25 |
| Comparative Example 1 | 190 | 25 | 38 | 1 |

Table 2

| | Visual observation | Resistance to delamination* (kg/cm) before heat cycle test | Resistance to delamination* (kg/cm) after heat cycle test | Resistance to molten solder-heat |
|---|---|---|---|---|
| Example 1 | good | 1.2 | 1.1 | good |
| 2 | " | 0.7 | 0.5 | " |
| 3 | " | 1.1 | 1.0 | " |
| 4 | " | 1.2 | 1.1 | " |
| 5 | " | 1.0 | 0.9 | " |
| 6 | " | 0.5 | 0.4 | " |
| 7 | " | 1.2 | 1.1 | " |
| 8 | " | 1.3 | 1.1 | " |
| 9 | " | 1.0 | 0.7 | " |
| 10 | " | 0.7 | 0.5 | " |
| Comparative Example 1 | good | 0.2 | delaminated | delaminated |

* by Method A

Comparative Example 2

Example 1 was repeated except for changing the surface temperature of the iron roll to 275°C, to obtain a laminate. The laminate obtained had a poor shape, having large thickness unevenness of the film

layer and containing cracks. The tensile strength of the film layer was only 20 $kg/mm^2$.

Example 11

The film obtained in Reference Example 1 was laid, one upon another, with an electrolytic copper foil having a thickness of 18$\mu$ m and a surface roughness of 11$\mu$ m and heat pressed by passing through the clearance of 92$\mu$ m between 2 chrome-plated iron rolls having a diameter of 300 mm. In this heat pressing, the 2 chrome-plated iron rolls were heated at a surface temperature of both 250 °C and the linear pressure and linear speed were set at 280 kg/cm and 1 m/min, respectively.

The laminate obtained had a good sheet shape and its resistance to delamination as measured by Method A was 1.2 kg/cm before heat cycle test and 1.0 kg/cm after the test.

Reference Example 2

A reaction vessel equipped with a stirrer and a vacuum distillation column was charged with 70 parts by weight of p-acetoxybenzoic acid and 30 parts by weight of 6-acetoxy-2-naphthoic acid. The inside of the vessel was fully replaced by nitrogen gas, and the vessel was heated to a temperature of 250 °C while nitrogen gas was being streamed thereinto. The contents were stirred at 250 °C for 3 hours and then at 280 °C for 1 hour and a quarter. The polymerization temperature was elevated to 320 °C and the system was kept at that temperature for 25 minutes. The system was then gradually evacuated and kept under the conditions of 0.1 to 0.2 mmHg and 320 °C for 25 minutes, after which the inside pressure was returned to atmospheric pressure and the obtained polymer was withdrawn.

The polymer thus obtained was capable of forming an optically anisotropic melt phase and had a melt viscosity as measured under the conditions of 300 °C and a shear rate of 100 $sec^{-1}$ of 2,700 poise.

The polymer was formed into a film having a thickness of 60 ± 3$\mu$ m by tubular film process using a single-screw extruder at a heating temperature of 280 to 300 °C and under the conditions of a draw ratio of 3.0 and a blow ratio of 3.2. The film thus obtained had a good appearance and showed a melting peak temperature as measured by DSC and at a temperature elevation rate of 10 °C/min of 275 °C.

Examples 12 through 21

The film obtained in Reference Example 2 was laid, one upon another, with a foil of electrolytic copper having a thickness of 18$\mu$ m and a surface roughness of 11$\mu$ m and heat pressed by passing through the nip between press rolls consisting of a rubber roll (Super Tempex, made by Seibu Polymer Chemical Co.) having a hardness of 93 degrees and a chrome-plated iron roll. When entering the rolls, the film contacted the rubber roll and the copper foil contacted the iron roll. The iron roll was heated with a heating device of heating-medium circulation type at a surface temperature of 250 °C. The areal pressure applied on the rubber roll and linear speed of the iron roll in each of the Examples are shown in Table 3. The results of evaluation on each of the obtained laminates are shown in Table 4.

The film layers of the laminates obtained in Examples 14, 17, 20 and 21 showed tensile strengths of 51 $kg/mm^2$, 49 $kg/mm^2$, 50 $kg/mm^2$ and 49 $kg/mm^2$, respectively.

Table 3

| | Areal pressure ($kg/cm^2$) | Linear speed (m/min) |
|---|---|---|
| Example 12 | 17 | 1 |
| 13 | 24 | 1 |
| 14 | 31 | 1 |
| 15 | 17 | 10 |
| 16 | 24 | 10 |
| 17 | 31 | 10 |
| 18 | 17 | 20 |
| 19 | 24 | 20 |
| 20 | 31 | 20 |
| 21 | 31 | 30 |

Table 4

| | Visual observation | Resistance to delamination* (kg/cm) Average | Range | Resistance to molten solder-heat |
|---|---|---|---|---|
| Example 12 | good | 0.59 | 0.15 | good |
| 13 | 〃 | 0.72 | 0.08 | 〃 |
| 14 | 〃 | 0.78 | 0.06 | 〃 |
| 15 | 〃 | 0.55 | 0.17 | 〃 |
| 16 | 〃 | 0.81 | 0.08 | 〃 |
| 17 | 〃 | 0.81 | 0.06 | 〃 |
| 18 | 〃 | 0.49 | 0.20 | deformed a little |
| 19 | 〃 | 0.75 | 0.10 | good |
| 20 | 〃 | 0.76 | 0.06 | 〃 |
| 21 | 〃 | 0.72 | 0.10 | 〃 |

* by Method B

Example 22

Example 12 was repeated except for changing the rubber roll contacting the film and having a hardness of 93 degrees to a silicone-rubber roll having a hardness of 60 degrees, to obtain a laminate. The areal pressure was 19 kg/cm$^2$, which was the highest achievable with the silicone-rubber roll, and the linear speed was 1 m/min.

The laminate obtained had a good sheet shape. The average of its resistance to delamination as measured by method B was 0.59 kg/cm and the range was 0.20 kg/cm. The laminate had a good resistance to molten solder-heat, showing no deformation or delamination.

Example 23

The film obtained in Reference Example 2 was laid, one upon another, with an electrolytic copper foil having a thickness of 18μ m and a surface roughness of 11μ m and heat pressed by passing through the clearance of 60μ m between 2 chrome-plated iron rolls having a diameter of 400 mm. In this heat pressing, one of the 2 chrome-plated iron rolls was heated at a surface temperature of 250 ° C and the linear pressure and linear speed were set at 200 kg/cm and 1 m/min, respectively.

The laminate obtained had a resistance to delamination as measured by Method B was 0.72 kg/cm on an average with the range being 0.20 kg/cm.

Example 24

On the copper foil side of each of the laminates obtained in Examples 1 through 23 was applied a photo resist solution to a uniform thickness by spin coating. After removal of solvent, the image (pattern) of a photo mask film was printed on the photo resist membrane formed on the surface of the copper foil of each of the laminates. The printing was performed by closely laying on the photo resist membrane the photo mask film having a pattern corresponding to the desired circuit and then irradiating ultraviolet light from above the photo mask film. After part of the photo resist membrane that had not been irradiated had been dissolved off, the exposed part of the copper foil was removed by chemical etching, whereby electric circuit was formed with copper foil on the liquid crystal polyester film. Thus, the desired FPC's were produced.

Obviously, numerous modifications and variations of the present invention are possible in light of the above teachings. It is therefore to be understood that within the scope of the appended claims, the invention may be practiced otherwise than as specifically described herein.

**Claims**

1. A laminate comprising a laminated structure obtained by placing in layers at least one film comprising a liquid crystal polymer capable of forming an optically anisotropic melt phase and at least one metal foil and pressing the resulting layers by passing them through a nip between press rolls at a temperature in a range of from 80 ° C below the melting point of said liquid crystal polymer to 5 ° C below the same melting point.

2. A laminate comprising a laminated structure obtained by placing in layers at least one single-layer film comprising a liquid crystal polymer capable of forming optically anisotropic melt phase and at least one metal foil and pressing the resulting layers at a temperature in a range of from 80 ° C below the melting point of said liquid crystal polymer to 5 ° C below the same melting point.

3. A laminate according to Claim 1 or 2, wherein said film and said metal foil are heat pressed under a pressure as converted into a linear pressure of at least 5 kg/cm or a pressure as converted into an areal pressure of at least 20 $kg/cm^2$.

4. A laminate according to any one of Claims 1 to 3, wherein said liquid crystal polymer is a thermotropic liquid crystal polyester consisting essentially of the following structural units (I) and (II)

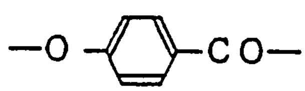

(I)

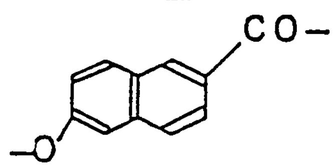

(II)

with the molar ratio between the structural unit (I) and the structural unit (II), [(I)/(II)], being in a range of from 90/10 to 10/90.

5. A process for producing laminates which comprises placing in layers at least one film comprising a liquid crystal polymer capable of forming an optically anisotropic melt phase and at least one metal foil and pressing the resulting layers by passing them through a nip between press rolls at a temperature in a range of from 80 ° C below the melting point of said liquid crystal polymer to 5 ° C below the same melting point.

6. A process according to Claim 5, wherein said film and said metal foil are heat pressed under a pressure as converted into a linear pressure of at least 5 kg/cm or a pressure as converted into an areal pressure of at least 20 $kg/cm^2$.

7. A process according to Claim 5 or 6, wherein said press rolls include at least one roll with a rubber surface having a hardness of at least 80 degrees.

8. A process according to any one of Claims 5 to 7, wherein said liquid crystal polymer is a thermotropic liquid crystal polyester consisting essentially of the following structural units (I) and (II)

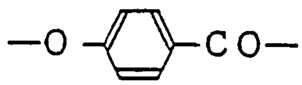

(I)

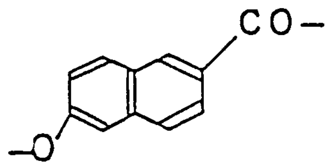

(II)

with the molar ratio between the structural unit (I) and the structural unit (II), [(I)/(II)], being in a range of from 90/10 to 10/90.

9. A flexible printed wiring board obtained by chemically etching the laminate of Claim 1 or 2 and comprising a structure that comprises a film comprising a liquid crystal polymer and a metal foil forming electric circuit, said film and said metal foil being laminated with each other.